# EUROPÄISCHE PATENTSCHRIFT

(11) **EP 3 835 463 B1**
(45) Veröffentlichungstag und Bekanntmachung des Hinweises auf die Patenterteilung: **19.08.2026**
(21) Anmeldenummer: 19216068.7
(22) Anmeldetag: 13.12.2019
(51) Int. Cl.: C30B 15/04, C30B 29/06

(54) **VERFAHREN UND VORRICHTUNG ZUR HERSTELLUNG EINES EINKRISTALLS AUS SILIZIUM, DER MIT DOTIERSTOFF VOM N-TYP DOTIERT IST**
METHOD AND DEVICE FOR PRODUCING A SINGLE CRYSTAL OF SILICON DOPED WITH N-TYPE DOPANT
PROCÉDÉ ET DISPOSITIF DE FABRICATION D'UN MONOCRISTAL EN SILICIUM, DOPÉ AVEC UNE SUBSTANCE DE DOPAGE DE TYPE N

(43) Veröffentlichungstag der Anmeldung: 16.06.2021
(73) Patentinhaber: Siltronic AG, 81677 München (DE)
(72) Erfinder: STAUDACHER, Wolfgang, 81735 München (DE); RAMING, Georg, 84367 Tann (DE)
(74) Vertreter: Killinger, Andreas

(56) Entgegenhaltungen:
- WO-A1-2009/119342
- CN-A- 1 600 905
- DE-T5- 112017 004 790
- US-A1- 2010 294 999

## Beschreibung

Gegenstand der Erfindung ist ein Verfahren zur Herstellung eines Einkristalls aus Silizium, der mit Dotierstoff vom n-Typ dotiert ist und in einem zylindrischen Abschnitt einen spezifischen elektrischen Widerstand von nicht mehr als 2mOhmcm aufweist, durch Ziehen des Einkristalls gemäß der CZ-Methode aus einer Schmelze, die in einem Tiegel enthalten ist. Gegenstand der Erfindung ist des Weiteren eine Vorrichtung zur Durchführung des Verfahrens.

### Stand der Technik / Probleme

Die Herstellung eines Einkristalls aus Silizium, der Dotierstoff vom n-Typ in vergleichsweise hoher Konzentration enthält, ist besonders herausfordernd. Der Dotierstoff ist leicht flüchtig und kann Ablagerungen ausbilden, die Versetzungen auslösen können. Es hat sich als vorteilhaft herausgestellt, Dotierstoff während einer Phase des Ziehens eines zylindrischen Abschnitts des wachsenden Einkristalls der Schmelze erstmalig oder zusätzlich zuzuführen.

In US 2010/ 0 294 999 A1 ist ein solches Verfahren beschrieben, das vorsieht, einen Gasstrom, der elementaren Dotierstoff enthält, durch ein Rohr zur Oberfläche der Schmelze zu blasen. Hierzu wird der feste Dotierstoff in der Ziehkammer sublimiert, und mit einem Trägergas versetzt zur Oberfläche der Schmelze geblasen. In vergleichbarer Weise wird bei einem Verfahren vorgegangen, das in JP 2013-129 551 A erläutert wird.

In CN 1 600 905 A und in DE 11 2017 004 790 T5 wird empfohlen, mehrere Öffnungen bereitzustellen, durch die gasförmiger Dotierstoff zur Oberfläche der Schmelze geblasen wird.

Nachteilig an diesen Vorschlägen ist, dass sie Modifikationen der näheren Umgebung (hot zone) des wachsenden Einkristalls erfordern, um dort Raum für das Sublimieren des Dotierstoffs zu schaffen, und dass die Verteilung des Dotierstoffs ungeachtet des Bereitstellens mehrerer Öffnungen zum Einblasen des Dotierstoffs ungleichmäßig ist.

Weiterhin wird in WO 2009/119342 A1 ein Verfahren sowie eine Vorrichtung zum Ziehen eines dotierten Silizium-Einkristalls aus einer Schmelze nach dem Czochralski-Verfahren mit einer Vielzahl von Speichermitteln zum Speichern eines sublimierbaren Dotierungsmittels, einer Zuführvorrichtung zum Zuführen des sublimierbaren Dotierungsmittels zu der Schmelze und einer Antriebsvorrichtung zum separaten Zuführen des sublimierbaren Dotierungsmittels von den Speichermitteln zu der Zuführvorrichtung beschrieben.

Aufgabe der Erfindung ist es, Modifikationen der hot zone zu minimieren und für eine gleichmäßigere Verteilung des Dotierstoffs in der Schmelze zu sorgen. Insbesondere sollen lokale Überhöhungen der Konzentration an Dotierstoff vermieden werden, deren Präsenz das Risiko erhöht, dass Versetzungen im wachsenden Einkristall ausgelöst werden.

Gelöst wird die Aufgabe durch ein Verfahren zur Herstellung eines Einkristalls aus Silizium, der mit Dotierstoff vom n-Typ dotiert ist und in einem zylindrischen Abschnitt einen spezifischen elektrischen Widerstand von nicht mehr als 2mOhmcm aufweist, durch Ziehen des Einkristalls gemäß der CZ-Methode aus einer Schmelze, die in einem Tiegel enthalten ist, umfassend im Verlauf des Ziehens des zylindrischen Abschnitts des Einkristalls das Zuführen eines Gasstroms enthaltend gasförmigen Dotierstoff zu einer Oberfläche der Schmelze, wobei der Gasstrom von einer Sublimations-Einrichtung außerhalb einer Ziehkammer in einem Rohrleitungssystem in die Ziehkammer und durch einen Hitzeschild, der den wachsenden Einkristall umgibt, oder entlang einer äußeren Oberfläche des Hitzeschilds, bis zu einem Ringkanal an einem unteren Ende des Hitzeschilds und von dort durch Düsen zur Oberfläche der Schmelze geleitet wird, dadurch gekennzeichnet dass mittels einer Wägezelle, einer Kamera mit Bildverarbeitung oder mittels der Wägezelle und der Kamera mit Bildverarbeitung der Verbrauch an Dotierstoff bestimmt wird.

Der zylindrische Abschnitt des Einkristalls weist teilweise oder vorzugsweise vollständig den spezifischen elektrischen Widerstand von nicht mehr als 2 mOhmcm auf. Im Fall von Phosphor als Dotierstoff beträgt der spezifische elektrische Widerstand im zylindrischen Abschnitt des Einkristalls vorzugweise nicht mehr als 1,2 mOhmcm, besonders bevorzugt nicht mehr als 1 mOhmcm.

Besondere Modifikationen der hot zone werden insbesondere dadurch vermieden, dass der Ort, wo fester Dotierstoff in gasförmigen Zustand sublimiert wird, außerhalb der Ziehkammer angeordnet wird. Darüber hinaus führt der Weg des gasförmigen Dotierstoffs in einem Rohrleitungssystem durch einen Hitzeschild oder entlang einer äußeren Oberfläche des Hitzeschilds bis zu einem Ringkanal am unteren Ende des Hitzeschilds und von dort durch Düsen zur Oberfläche der Schmelze.

Die äußere Oberfläche des Hitzeschilds bezeichnet die Seitenfläche des Hitzeschilds, auf die die Wärmestrahlung einer um den Tiegel angeordneten Heizeinrichtung (Tiegelheizer) zuerst auftrifft.

Der Dotierstoff wird außerhalb der Ziehkammer sublimiert und zusammen mit einem Trägergas durch das Rohrleitungssystem in den Ringkanal gespült und von dort durch die Düsen zur Oberfläche der Schmelze geleitet.

Es werden mindestens zwei, vorzugsweise 4 bis 100 Düsen bereitgestellt. Die Spitzen der Düsen, wo der Gasstrom aus Trägergas und Dotierstoffgas austritt, haben einen Abstand von vorzugsweise nicht mehr als 20 mm zur Oberfläche der Schmelze.

Mit Hilfe der Anordnung der Düsen wird der Gasstrom in vorbestimmter Weise auf die Oberfläche der Schmelze geleitet.

Die Düsen können derart angeordnet sein, dass der Gasstrom in eine Richtung senkrecht zur Oberfläche der Schmelze geleitet wird oder hin zur Oberfläche der Schmelze mit einer Richtungskomponente hin zu einer Achse durch die Mitte des wachsenden Einkristalls oder hin zur Oberfläche der Schmelze mit einer Richtungskomponente weg von der Achse durch die Mitte des wachsenden Einkristalls.

Vorzugsweise sind die Düsen derart angeordnet, dass der Gasstrom benachbarter Düsen in jeweils unterschiedliche Richtungen geleitet wird, beispielsweise abwechselnd in zwei oder drei der drei vorstehend benannten Richtungen, also beispielsweise abwechselnd in Richtung senkrecht zur Oberfläche der Schmelze und in Richtung hin zur Achse durch die Mitte des wachsenden Einkristalls oder abwechselnd in Richtung hin zur Achse durch die Mitte des wachsenden Einkristalls und in Richtung weg von der Achse durch die Mitte des wachsenden Einkristalls.

Besonders bevorzugt ist es, die Düsen schwenkbar auszuführen und deren Austrittsöffnungen vor dem Einbau des Hitzeschilds so auszurichten, dass die Düsen während des Ziehens des zylindrischen Abschnitts eine gewünschte Anordnung einnehmen.

Das Leiten des Gasstroms zur Oberfläche der Schmelze während des Ziehens des zylindrischen Abschnitts des Einkristalls kann permanent oder zeitweise erfolgen. Sollte die Schmelze zu Beginn des Ziehens des zylindrischen Abschnitts des Einkristalls vergleichsweise wenig oder keinen Dotierstoff enthalten, wird der Gasstrom zu diesem Zeitpunkt zur Oberfläche der Schmelze geleitet. Die Volumengeschwindigkeit des Gasstroms kann gleichbleibend oder wechselnd eingestellt sein. Beispielsweise kann die Volumengeschwindigkeit des Gasstroms mit zunehmender Kristallisation des Einkristalls verringert werden, um die Anreicherung von Dotierstoff in der Schmelze durch Segregation auszugleichen.

Der Dotierstoff besteht vorzugsweise aus einem oder mehreren der Elemente Phosphor, Arsen und Antimon, die in einer Einrichtung zum Sublimieren von Dotierstoff (Sublimations-Einrichtung) in gasförmigen Zustand versetzt werden. Es ist aber auch nicht ausgeschlossen, Dotierstoff von einer oder mehreren chemischen Verbindungen dieser Elemente einzusetzen, die bereits gasförmig sind, beispielsweise von Verbindungen dieser Elemente mit Wasserstoff. In diesem Fall wird die Sublimations-Einrichtung nur dazu verwendet, um Dotierstoffgas und Trägergas zu mischen.

Gegenstand der Erfindung ist auch eine Vorrichtung zur Herstellung eines Einkristalls aus Silizium, der mit Dotierstoff vom n-Typ dotiert ist und in einem zylindrischen Abschnitt einen spezifischen elektrischen Widerstand von nicht mehr als 2mOhmcm aufweist, umfassend
eine Ziehkammer zum Ziehen des Einkristalls gemäß der CZ-Methode;
einen Tiegel zur Aufnahme einer Schmelze aus Silizium;
einen Hitzeschild zum Abschirmen eines wachsenden Einkristalls;
eine Sublimations-Einrichtung zum Überführen von festem Dotierstoff in gasförmigen Dotierstoff, und ein Rohrleitungssystem zum Zuführen eines den gasförmigen Dotierstoff enthaltenden Gasstroms zu einer Oberfläche der Schmelze,
wobei die Sublimations-Einrichtung außerhalb der Ziehkammer angeordnet ist und das Rohrleitungssystem durch den Hitzeschild oder entlang einer äußeren Oberfläche des Hitzeschilds führt und in einem Ringkanal am
unteren Ende des Hitzeschilds mündet, und der Ringkanal Düsen zum Leiten des Gasstroms zur Oberfläche der Schmelze aufweist, gekennzeichnet durch eine Wägezelle, durch eine Kamera mit Bildverarbeitung oder durch die Wägezelle und die Kamera mit Bildverarbeitung, zur Bestimmung des Verbrauchs an Dotierstoff.

Der Ringkanal und die Düsen bestehen vorzugsweise aus einem besonders korrosionsbeständigem Material wie beispielsweise Molybdän, ebenso wie zumindest der Teil des Rohrleitungssystems, dessen Abstand zur Oberfläche der Schmelze nicht mehr als 200 mm beträgt.

Außerhalb der Ziehkammer ist eine Sublimations-Einrichtung angeordnet, die einen Behälter für Dotierstoff und eine ihn umgebende Behälterheizung umfasst. Die Behälterheizung kann über mehrere getrennt steuerbare Heizzonen verfügen, was die Kontrolle über die Menge an sublimierende Dotierstoff verbessert. Darüber hinaus ist eine Wägezelle vorhanden, die die Änderung des Gewichts des Inhalts des Behälters während des Ziehens des Einkristalls erfasst. Aus diesen Informationen lässt sich der Verbrauch des Dotierstoffs ermitteln und die weitere Zufuhr von Dotierstoff zur Schmelze gezielt steuern. Anstelle der oder zusätzlich zur Wägezelle kann eine Kamera mit Bildverarbeitung vorgesehen sein, mit deren Hilfe der Verbrauch an Dotierstoff bestimmt wird.

Eingangsseitig ist die Sublimations-Einrichtung mit einem Durchflussregler verbunden, mit dessen Hilfe Trägergas und Dotierstoffgas in der Sublimations-Einrichtung gemischt und in die Ziehkammer geleitet werden. Ausgangsseitig verbindet ein Teil des Rohrleitungssystems die Sublimations-Einrichtung mit einem Flansch an der Außenwand der Ziehkammer. Von dort führt das Rohrleitungssystem weiter bis zu einem Ringkanal am unteren Ende eines Hitzeschilds, der den wachsenden Einkristall umgibt. Der Hitzeschild ist feststehend relativ zur Oberfläche der Schmelze montiert.

Es sollte verhindert werden, dass sich sublimierter Dotierstoff im Rohrleitungssystem als Feststoff niederschlägt. Es ist daher bevorzugt, den Teil des Rohrleitungssystems, der zwischen der Sublimations-Einrichtung und der Ziehkammer angeordnet ist, inklusive des Bereichs des Flansches an der Außenwand der Ziehkammer, thermisch zu isolieren oder bereichsweise oder vollständig mit einer Rohrleitungsheizung zu versehen und mittels dieser von außen zu erhitzen.

Der Durchflussregler, die Wägezelle und die Behälterheizung sind vorzugsweise an eine Regelungsvorrichtung der Vorrichtung zum Ziehen des Einkristalls angeschlossen. Sie verarbeitet deren Daten und regelt die Heizleistung der Behälterheizung und die Abgabe an Trägergas durch den Durchflussregler, um eine vorbestimmte oder im Zuge eines Regelkreises errechnete Dotierstoffzufuhr zur Schmelze zu gewährleisten.

Gemäß einer ersten Ausgestaltung der Erfindung führt das Rohrleitungssystem weiter durch den Hitzeschild bis zum Ringkanal. Gemäß einer zweiten Ausgestaltung der Erfindung führt das Rohrleitungssystem weiter entlang der äußeren Oberfläche des Hitzeschilds bis zum Ringkanal.

Über die untere Seite des Ringkanals sind Düsen gleichmäßig verteilt, die zur Oberfläche der Schmelze weisen. Die Anzahl der Düsen beträgt vorzugsweise 4 bis 100 Düsen. Die Düsen sind in vorbestimmter Weise angeordnet. Eine mögliche Anordnung sieht vor, dass alle Düsen senkrecht zur Oberfläche der Schmelze ausgerichtet sind, so dass der Gasstrom nahezu im rechten Winkel auf die Oberfläche der Schmelze auftrifft. Eine weitere Anordnung sieht vor, dass die Düsen radial zum Einkristall hin gekippt ausgerichtet sind, also mit einer Richtungskomponente hin zu einer Achse durch die Mitte des wachsenden Einkristalls. Eine weitere Anordnung sieht vor, dass die Düsen radial vom Einkristall weggekippt ausgerichtet sind, also mit einer Richtungskomponente weg von der Achse durch die Mitte des wachsenden Einkristalls.

Besonders bevorzugt ist eine Anordnung, bei der die Ausrichtung benachbarter Düsen unterschiedlich ist, beispielsweise eine solche, bei der sich die Ausrichtung der Düsen abwechselt zwischen der Anordnung senkrecht zur Oberfläche, der gekippten Anordnung hin zum Einkristall und der gekippten Anordnung weg vom Einkristall.

Die Erfindung wird nachfolgend unter Bezugnahme auf Zeichnungen weiter erläutert.

### Kurzbeschreibung der Figuren

**Fig. 1** zeigt eine Vorrichtung gemäß einer ersten Ausgestaltung der Erfindung.
**Fig. 2** zeigt eine Vorrichtung gemäß einer zweiten Ausgestaltung der Erfindung.
**Fig. 3** zeigt mögliche Anordnungen der Düsen, die vom Ringkanal zur Oberfläche der Schmelze gerichtet sind.

### Liste der verwendeten Bezugszeichen

- **1**: wachsender Einkristall
- **2**: Ziehkammer
- **3**: Wärmedämmung
- **4**: Gaseinlass
- **5**: Gasauslass
- **6**: Tiegelheizer
- **7**: Ringkanal
- **8**: äußerer Tiegel
- **9**: innerer Tiegel
- **10**: Hitzeschild
- **11**: Rohrleitungssystem
- **12**: Tiegelwellenantrieb
- **13**: Tiegelwelle
- **14**: Ziehwelle
- **15**: Ziehwellenantrieb
- **16**: Keimkristallhalter
- **17**: Keimkristall
- **18**: Einrichtung zum Erzeugen eines Magnetfelds
- **19**: Regelungsvorrichtung
- **20**: Oberfläche der Schmelze
- **21**: Einrichtung zum Sublimieren von Dotierstoff
- **22**: Düse
- **23**: Behälter für Dotierstoff
- **24**: Behälterheizung
- **25**: Wägezelle
- **26**: Durchflussregler
- **27**: Trägergas
- **28**: Achse durch die Mitte des wachsenden Einkristalls
- **29**: Rohrleitungsheizung

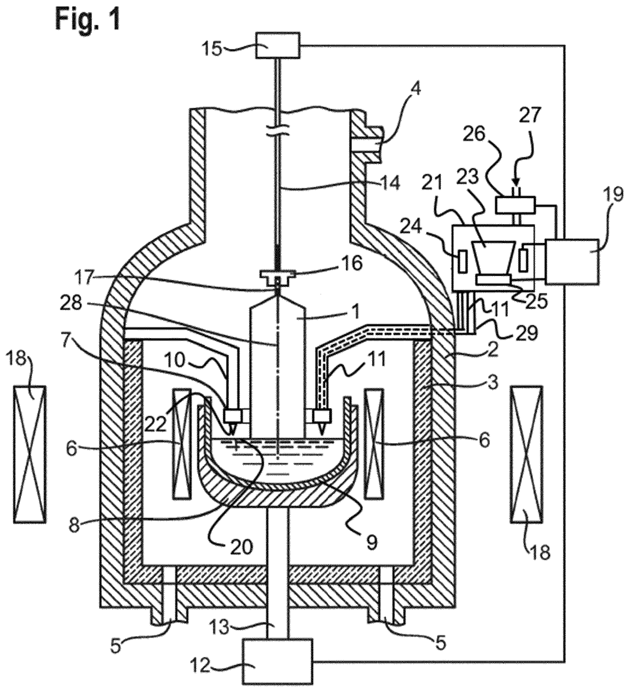

Die Vorrichtung gemäß Fig.1 umfasst eine Ziehkammer 2, die einen inneren Tiegel 9 beherbergt, der mit Hilfe einer Tiegelwelle 13 gedreht, angehoben und abgesenkt werden kann. Der innere Tiegel 9 wird von einem äußeren Tiegel 8 gestützt. Die Tiegelwelle 13 wird durch einen Tiegelwellenantrieb 12 in Bewegung versetzt, der an eine Regelungsvorrichtung 19 der Vorrichtung zum Ziehen des Einkristalls angeschlossen ist. Eine Wärmedämmung 3 schirmt die innere Wand der Ziehkammer von Wärmestrahlung ab, die ein Tiegelheizer 6 abgibt, der um die Tiegel 8, 9 angeordnet ist. Die Ziehkammer 2 umfasst des Weiteren einen Gaseinlass 4 und einen Gasauslass 5 zum Durchleiten eines Prozessgases wie Argon oder eines Prozessgasgemisches wie Argon und Wasserstoff während des Ziehens eines Einkristalls. Ein Hitzeschild 10, der feststehend montiert ist, umgibt während des Betriebs der Vorrichtung einen wachsenden Einkristall 1. Der Einkristall 1 wächst an einem Keimkristall 17, der in einem Keimkristallhalter 16 eingespannt ist, und wird mit Hilfe eines Ziehmechanismus, beispielsweise einer Ziehwelle 14 und eines Ziehwellenantriebs 15 von der Oberfläche 20 einer Schmelze aus Silizium nach oben gezogen und währenddessen um die Achse 28 durch seine Mitte gedreht. Die Ziehkammer 2 ist von einer Einrichtung 18 zum Erzeugen eines Magnetfelds, beispielsweise eines horizontalen Magnetfelds oder eine CUSP-Magnetfelds umgeben.

Erfindungsgemäß ist vorgesehen, außerhalb der Ziehkammer 2 eine Einrichtung 21 zum Sublimieren von Dotierstoff (Sublimations-Einrichtung) anzuordnen und sie mit einem Rohrleitungssystem 11 zu verbinden, das Dotierstoff, der in der Sublimations-Einrichtung 21 in gasförmigen Zustand überführt wurde, in Form eines Gasstroms, der den gasförmigen Dotierstoff und ein Trägergas 27 enthält, in einen Ringkanal 7 und von dort durch Düsen 22 zur Oberfläche 20 der Schmelze leitet. Der Ringkanal ist am unteren Ende des Hitzeschilds 10 angeordnet. Die Sublimations-Einrichtung 21 umfasst einen Behälter 23 für Dotierstoff, eine Behälterheizung 24 und eine Wägezelle 25. Die Behälterheizung 24, die Wägezelle und ein Durchflussregler 26, durch den das Trägergas dem gasförmigen Dotierstoff zugeführt wird, sind an die Regelungsvorrichtung 19 angeschlossen. Vorzugsweise ist um das Rohrleitungssystem 11 im Bereich außerhalb der Ziehkammer 2 bereichsweise oder vollständig eine Rohrleitungsheizung 29 zum Erhitzen des Rohrleitungssystems 11 angeordnet.

Gemäß der in Fig.1 gezeigten Ausführungsform führt das Rohrleitungssystem 11 durch den Hitzeschild 19 und mündet in den Ringkanal 7.

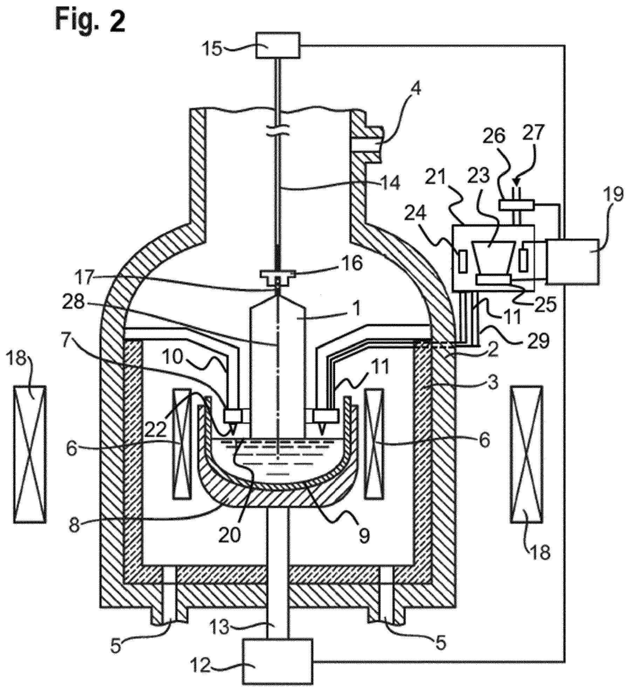

Gemäß der in Fig.2 gezeigten Ausführungsform führt das Rohrleitungssystem 11 entlang der äußeren Oberfläche des Hitzeschilds 19 in den Ringkanal 7.

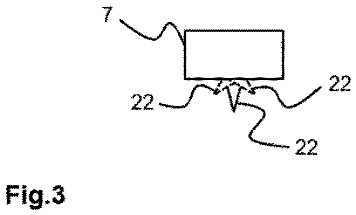

Die Düsen 22 sind über die der Oberfläche der Schmelze gegenüberliegenden Seite des Ringkanals 7 verteilt angeordnet, vorzugsweise mit gleichmäßigem Abstand, und zur Oberfläche 20 der Schmelze gerichtet, entweder nur mit einer Richtungskomponente parallel zur Achse 28 durch die Mitte des wachsenden Einkristalls oder mit einer zusätzlichen Richtungskomponente hin zu dieser Achse oder mit einer zusätzlichen Richtungskomponente weg von dieser Achse. Fig.3 zeigt Beispiele solcher Anordnungen der Düse. Besonders bevorzugt ist eine Anordnung der Düsen, die abwechselnd zwei oder drei dieser drei Möglichkeiten umsetzt.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zur Herstellung eines Einkristalls aus Silizium, der mit Dotierstoff vom n-Typ dotiert ist und in einem zylindrischen Abschnitt einen spezifischen elektrischen Widerstand von nicht mehr als 2mOhmcm aufweist, durch Ziehen des Einkristalls gemäß der CZ-Methode aus einer Schmelze, die in einem Tiegel enthalten ist, umfassend
im Verlauf des Ziehens des zylindrischen Abschnitts des Einkristalls das Zuführen eines Gasstroms enthaltend gasförmigen Dotierstoff zu einer Oberfläche der Schmelze, wobei der Gasstrom von einer Sublimations-Einrichtung außerhalb einer Ziehkammer in einem Rohrleitungssystem in die Ziehkammer und durch einen Hitzeschild, der den wachsenden Einkristall umgibt, oder entlang einer äußeren Oberfläche des Hitzeschilds, bis zu einem Ringkanal an einem unteren Ende des Hitzeschilds und von dort durch Düsen zur Oberfläche der Schmelze geleitet wird, **dadurch gekennzeichnet dass** mittels einer Wägezelle, einer Kamera mit Bildverarbeitung oder mittels der Wägezelle und der Kamera mit Bildverarbeitung der Verbrauch an Dotierstoff bestimmt wird.

2. Verfahren nach Anspruch 1, **dadurch gekennzeichnet, dass** der Dotierstoff in Form einer chemischen Verbindung oder in molekularer oder atomarer Form eines Elements des Dotierstoffs zur Oberfläche der Schmelze geleitet wird, und der Dotierstoff eines oder mehrere der Elemente P, As und Sb umfasst.

3. Verfahren nach Anspruch 1 oder Anspruch 2, **dadurch gekennzeichnet, dass** der Dotierstoff durch mindestens zwei Düsen zur Oberfläche der Schmelze geleitet wird.

4. Verfahren nach einem der Ansprüche 1 bis 3, **dadurch gekennzeichnet, dass** der Gasstrom von den Düsen in eine Richtung senkrecht zur Oberfläche der Schmelze geleitet wird oder hin zur Oberfläche der Schmelze in eine Richtung weg von einer Achse durch die Mitte des Einkristalls oder hin zur Oberfläche der Schmelze in eine Richtung hin zur Achse durch die Mitte des Einkristalls.

5. Verfahren nach Anspruch 1 oder Anspruch 2, **dadurch gekennzeichnet, dass** der Gasstrom von benachbarten Düsen wegen deren Anordnung in jeweils unterschiedliche Richtungen zur Oberfläche der Schmelze geleitet wird, wobei sich eine Anordnung senkrecht zur Oberfläche der Schmelze, eine gekippte Anordnung hin zum Einkristall und eine gekippte Anordnung weg vom Einkristall abwechseln.

6. Verfahren nach einem der Ansprüche 1 bis 5, **dadurch gekennzeichnet, dass** das Rohrleitungssystem im Bereich außerhalb der Ziehkammer von außen bereichsweise oder vollständig erhitzt wird.

7. Vorrichtung zur Herstellung eines Einkristalls aus Silizium, der mit Dotierstoff vom n-Typ dotiert ist und in einem zylindrischen Abschnitt einen spezifischen elektrischen Widerstand von nicht mehr als 2mOhmcm aufweist, umfassend eine Ziehkammer zum Ziehen des Einkristalls gemäß der CZ-Methode;
einen Tiegel zur Aufnahme einer Schmelze aus Silizium;
einen Hitzeschild zum Abschirmen eines wachsenden Einkristalls;
eine Sublimations-Einrichtung zum Überführen von festem Dotierstoff in gasförmigen Dotierstoff, und ein Rohrleitungssystem zum Zuführen eines den gasförmigen Dotierstoff enthaltenden Gasstroms zu einer Oberfläche der Schmelze,
wobei die Sublimations-Einrichtung außerhalb der Ziehkammer angeordnet ist und das Rohrleitungssystem durch den Hitzeschild oder entlang einer äußeren Oberfläche des Hitzeschilds führend in einem Ringkanal am unteren Ende des Hitzeschilds mündet, und der Ringkanal Düsen zum Leiten des Gasstroms zur Oberfläche der Schmelze aufweist, **gekennzeichnet durch** eine Wägezelle, durch eine Kamera mit Bildverarbeitung oder durch die Wägezelle und die Kamera mit Bildverarbeitung, zur Bestimmung des Verbrauchs an Dotierstoff.

8. Vorrichtung nach Anspruch 7, **dadurch gekennzeichnet, dass** mindestens zwei Düsen vorhanden sind.

9. Vorrichtung nach Anspruch 7 oder Anspruch 8, **dadurch gekennzeichnet, dass** die Düsen mit gleichmäßigem Abstand über den Ringkanal verteilt sind.

10. Vorrichtung nach einem der Ansprüche 7 bis 9, **dadurch gekennzeichnet, dass** benachbarte Düsen derart angeordnet sind, dass der Gasstrom in jeweils unterschiedliche Richtungen zur Oberfläche der Schmelze geleitet wird, wobei sich eine Anordnung senkrecht zur Oberfläche der Schmelze, eine gekippte Anordnung hin zum Einkristall und eine gekippte Anordnung weg vom Einkristall abwechseln.

11. Vorrichtung nach einem der Ansprüche 7 bis 10, **gekennzeichnet durch** eine Rohleitungsheizung, die das Rohrleitungssystem im Bereich außerhalb der Ziehkammer bereichsweise oder vollständig von außen erhitzt.

## Claims

1. Method for producing a single silicon crystal doped with n-type dopant and having in a cylindrical portion an electrical resistivity of not more than 2 mohmcm, by pulling of the single crystal by the CZ method from a melt contained in a crucible, comprising
in the course of the pulling of the cylindrical portion of the single crystal, the supplying of a gas stream comprising gaseous dopant to a surface of the melt, the gas stream being guided from a sublimation facility outside a pulling chamber in a tubing system into the pulling chamber and through a heat shield which surrounds the growing single crystal, or along an outer surface of the heat shield, to an annular channel on a lower end of the heat shield and from there through nozzles to the surface of the melt, **characterized in that**, by means of a weighing cell, a camera with image processing or by means of the weighing cell and the camera with image processing, the dopant consumption is ascertained.

2. Method according to Claim 1, **characterized in that** the dopant in the form of a chemical compound or in a molecular or atomic form of an element of the dopant is guided to the surface of the melt, and the dopant comprises one or more of the elements P, As and Sb.

3. Method according to Claim 1 or Claim 2, **characterized in that** the dopant is guided through at least two nozzles to the surface of the melt.

4. Method according to any of Claims 1 to 3, **characterized in that** the gas stream is guided by the nozzles in a direction perpendicular to the surface of the melt or toward the surface of the melt in a direction away from an axis through the middle of the single crystal or toward the surface of the melt in a direction toward the axis through the middle of the single crystal.

5. Method according to Claim 1 or Claim 2, **characterized in that** the gas stream is guided to the surface of the melt by adjacent nozzles in respectively different directions on account of their arrangement, with alternation of an arrangement perpendicular to the surface of the melt, a tilted arrangement toward the single crystal and a tilted arrangement away from the single crystal.

6. Method according to any of Claims 1 to 5, **characterized in that** the tubing system is heated regionally or completely from the outside in the region outside the pulling chamber.

7. Apparatus for producing a single silicon crystal doped with an n-type dopant and having in a cylindrical portion an electrical resistivity of not more than 2 mohmcm, comprising
a pulling chamber for pulling the single crystal by the CZ method;
a crucible for accommodating a melt of silicon;
a heat shield for shielding a growing single crystal;
a sublimation facility for converting solid dopant into gaseous dopant, and a tubing system for supplying a gas stream comprising the gaseous dopant to a surface of the melt,
wherein the sublimation facility is arranged outside the pulling chamber, and the tubing system, leading through the heat shield or along an outer surface of the heat shield, opens out in an annular channel at the lower end of the heat shield, and the annular channel has nozzles for guiding the gas stream to the surface of the melt, **characterized by** a weighing cell, by a camera with image processing or by the weighing cell and the camera with image processing, for ascertaining the dopant consumption.

8. Apparatus according to Claim 7, **characterized in that** there are at least two nozzles.

9. Apparatus according to Claim 7 or Claim 8, **characterized in that** the nozzles are distributed with uniform spacing over the annular channel.

10. Apparatus according to any of Claims 7 to 9, **characterized in that** adjacent nozzles are arranged such that the gas stream is guided to the surface of the melt in respectively different directions, with alternation of an arrangement perpendicular to the surface of the melt, a tilted arrangement toward the single crystal and a tilted arrangement away from the single crystal.

11. Apparatus according to any of Claims 7 to 10, **characterized by** a tubing heater which heats the tubing system regionally or completely from the outside in the region outside the pulling chamber.

## Revendications

1. Procédé de préparation d'un monocristal de silicium, qui est dopé par une substance de dopage de type n et qui présente, dans une section cylindrique, une résistance électrique spécifique inférieure ou égale à 2 mOhm.cm, par tirage d'un monocristal selon la méthode CZ à partir d'une masse fondue qui est contenue dans un creuset, comprenant
au cours du tirage de la section cylindrique du monocristal, l'apport d'un flux gazeux contenant la substance de dopage gazeuse à une surface de la masse fondue, le flux gazeux étant guidé à partir d'un système de sublimation en dehors d'une chambre de tirage dans un système de conduites tubulaires dans la chambre de tirage et à travers un bouclier thermique, qui entoure le monocristal en croissance, ou le long d'une surface externe du bouclier thermique, jusqu'à un canal annulaire au niveau d'une extrémité inférieure du bouclier thermique et, de là, à travers des buses jusqu'à la surface de la masse fondue, **caractérisé en ce que** la consommation en substance de dopage est déterminée au moyen d'un capteur de pesage, d'une caméra pourvue d'un traitement d'images ou au moyen du capteur de pesage et de la caméra pourvue d'un traitement d'images.

2. Procédé selon la revendication 1, **caractérisé en ce que** la substance de dopage est guidée sous forme d'un composé chimique ou sous forme moléculaire ou atomique d'un élément de la substance de dopage vers la surface de la masse fondue et la substance de dopage comprend un ou plusieurs des éléments P, As et Sb.

3. Procédé selon la revendication 1 ou la revendication 2, **caractérisé en ce que** la substance de dopage est guidée à travers au moins deux buses vers la surface de la masse fondue.

4. Procédé selon l'une des revendications 1 à 3, **caractérisé en ce que** le flux gazeux est guidé par les buses dans une direction perpendiculaire à la surface de la masse fondue ou vers la surface de la masse fondue dans une direction s'éloignant d'un axe à travers le centre du monocristal ou vers la surface de la masse fondue dans une direction vers l'axe à travers le centre du monocristal.

5. Procédé selon la revendication 1 ou la revendication 2, **caractérisé en ce que** le flux gazeux est guidé par des buses adjacentes, en raison de leur agencement, dans des sens à chaque fois différents vers la surface de la masse fondue, l'agencement alternant entre un agencement perpendiculaire à la surface de la masse fondue, un agencement basculé vers le monocristal et un agencement basculé à l'opposé du monocristal.

6. Procédé selon l'une des revendications 1 à 5, **caractérisé en ce que** le système de conduites tubulaires est chauffé dans la zone en dehors de la chambre de tirage, depuis l'extérieur, par zones ou complètement.

7. Dispositif pour la préparation d'un monocristal de silicium, qui est dopé par une substance de dopage de type n et qui présente, dans une section cylindrique, une résistance électrique spécifique inférieure ou égale à 2 mOhm.cm, comprenant
une chambre de tirage destinée à tirer monocristal selon la méthode CZ ;
un creuset destiné à recevoir une masse fondue de silicium ;
un bouclier thermique destiné à protéger un monocristal en croissance ;
un système de sublimation destiné à transférer la substance de dopage solide en une substance de dopage gazeuse et un système de conduites tubulaires pour l'apport d'un flux gazeux contenant la substance de dopage gazeuse à une surface de la masse fondue,
dans lequel le système de sublimation est agencé en dehors de la chambre de tirage et le système de conduites tubulaires passe à travers le bouclier thermique ou le long d'une surface externe du bouclier thermique et débouche dans un canal annulaire au niveau de l'extrémité inférieure du bouclier thermique et le canal annulaire présente des buses pour le guidage du flux gazeux vers la surface de la masse fondue, **caractérisé par** un capteur de pesage, par une caméra pourvue d'un traitement d'images ou par le capteur de pesage et la caméra pourvue d'un traitement d'images, pour la détermination de la consommation de substances de dopage.

8. Dispositif selon la revendication 7, **caractérisé en ce qu'**il présente au moins deux buses.

9. Dispositif selon la revendication 7 ou la revendications 8, **caractérisé en ce que** les buses sont réparties à une distance régulière sur le canal annulaire.

10. Dispositif selon l'une des revendications 7 à 9, **caractérisé en ce que** des buses adjacentes sont agencées de telle sorte que le flux gazeux est guidé dans des sens à chaque fois différents vers la surface de la masse fondue, un agencement perpendiculaire à la surface de la masse fondue, un agencement basculé vers le monocristal et un agencement basculé à l'opposé du cristal alternant.

11. Dispositif selon l'une des revendications 7 à 10, **caractérisé par** un chauffage à conduites tubulaires qui chauffe, par zones ou complètement, depuis l'extérieur, le système de conduites tubulaires dans la zone en dehors de la chambre de tirage.
